# EUROPEAN PATENT APPLICATION

(11) **EP 4 797 901 A1**
(43) Date of publication of application: **26.08.2026**
(21) Application number: 26153842.5
(22) Date of filing: 23.01.2026
(51) Int. Cl.: H10D 1/68, H10D 1/00, H10B 12/00

(54) **CAPACITOR STRUCTURE AND METHOD OF FORMING THE SAME, AND SEMICONDUCTOR DEVICE INCLUDING THE CAPACITOR STRUCTURE**

(30) Priority: 24.02.2025 KR 20250023594
(71) Applicant: Samsung Electronics Co., Ltd., Suwon-si, Gyeonggi-do 16677 (KR)
(72) Inventor: CHAE, Hongsik, 16677 Suwon-si (KR); LEE, Donggeon, 16677 Suwon-si (KR); KANG, Jungoo, 16677 Suwon-si (KR); KIM, Beomjong, 16677 Suwon-si (KR); JUNG, Hyungsuk, 16677 Suwon-si (KR)
(74) Representative: Marks & Clerk LLP

(57) **Abstract**

An example capacitor structure includes a lower electrode structure (70), a dielectric pattern (95) and an upper electrode (105). The lower electrode structure (70) includes a first lower electrode (65) on a substrate (10), and a second lower electrode (62) on a sidewall of the first lower electrode (65). The second lower electrode (62) includes an alloy of a first metal and a second metal. The dielectric pattern (95) is disposed on a surface of the lower electrode structure (70). The upper electrode (105) is disposed on a surface of the dielectric pattern (95). The second lower electrode (62) has a thickness varying in a vertical direction perpendicular to an upper surface of the substrate (10). A weight ratio between the first metal and the second metal is uniform in the vertical direction in the second lower electrode (62).

## Description

The invention relates to a capacitor structure and a method of forming the same, and a semiconductor device including the capacitor structure.

### BACKGROUND

A capacitor structure of a DRAM device includes a capacitor having a lower electrode, a dielectric layer and an upper electrode sequentially stacked, and support layers contacting a surface of the lower electrode and being spaced apart from each other in a vertical direction.

### SUMMARY

The present disclosure relates to a capacitor structure having improved characteristics, a semiconductor device including a capacitor structure having improved characteristics, and a method of forming a capacitor structure having improved characteristics.

In one aspect the invention provides a capacitor structure including, a lower electrode structure, a dielectric pattern oma surface of the lower electrode structure, and an upper electrode on a surface of the dielectric pattern. The lower electrode structure includes a first lower electrode on a substrate, and a second lower electrode on a sidewall of the first lower electrode. The second lower electrode including an alloy of a first metal and a second metal. The second lower electrode has a thickness varying in a vertical direction perpendicular to an upper surface of the substrate. A weight ratio between the first metal and the second metal is uniform in the vertical direction in the second lower electrode.

In some implementations, a capacitor structure may include a lower electrode structure, a dielectric pattern and an upper electrode. The lower electrode structure may include a first lower electrode on a substrate and extending in a vertical direction perpendicular to an upper surface of the substrate, and a second lower electrode on a sidewall of the first lower electrode and including an alloy of niobium and titanium. The dielectric pattern may be disposed on a sidewall of the lower electrode structure. The upper electrode may be disposed on a sidewall of the dielectric pattern. A weight ratio between niobium and titanium may be uniform in the vertical direction in the second lower electrode.

In some implementations, a semiconductor device may include an active pattern, a gate structure, a bit line structure, at least one contact plug structure and a capacitor structure. The active pattern may be disposed on a substrate. The gate structure may be disposed in an upper portion of the active pattern, and may extend in a first direction parallel to an upper surface of the substrate. The bit line structure may extend in a second direction parallel to the upper surface of the substrate and crossing the first direction, and may be disposed on a central portion of the active pattern. The at least one contact plug structure may be disposed on each of opposite end portions of the active pattern. The capacitor structure may be disposed on the at least one contact plug structure. The capacitor structure may include at least one lower electrode structure, support layers, a dielectric pattern and an upper electrode. The least one lower electrode structure may include a first lower electrode extending in a vertical direction perpendicular to the upper surface of the substrate, and a second lower electrode on a sidewall of the first lower electrode. The second lower electrode may have a thickness varying in the vertical direction and include an alloy of a first metal and a second metal. The support layers may be spaced apart from each other in the vertical direction on a sidewall of the at least one lower electrode structure. The dielectric pattern may be disposed on a sidewall of a portion of the at least one lower electrode structure between the support layers. The upper electrode may be disposed on a surface of the dielectric pattern. A weight ratio between the first metal and the second metal may be uniform in the vertical direction in the second lower electrode.

The capacitor structure in accordance with example implementations may have a uniform capacitance in the vertical direction even though the lower electrode structure included in the capacitor structure has a varying thickness in the vertical direction.
At least some of the above and other features of the invention are set out in the claims.

### BRIEF DESCRIPTION OF THE DRAWINGS

FIG. 1 is a cross-sectional view illustrating an example of a capacitor structure.
FIG. 2 is enlarged view of region X of FIG. 1.
FIGS. 3, 4, 5, 6, 7, 8, and 9 are cross-sectional views illustrating an example of a method of forming a capacitor structure.
FIG. 10 is a cross-sectional view illustrating a comparative example of a capacitor structure and FIG. 11 os an enlarged view of region Y of FIG. 10.
FIG. 12 is a plan view illustrating an example of a semiconductor device, and FIG. 13 is an example cross-sectional view taken along line A-A' of FIG. 12.
FIGS. 14, 15, 16, 17, 18, 19, 20, 21, 22, 23, 24, 25, 26, 27, 28, and 29 are plan views and cross-sectional views illustrating an example of a method of manufacturing a semiconductor device.

### DETAILED DESCRIPTION

The above and other aspects and features of a capacitor structure and a method of forming the same, and a semiconductor device and a method of manufacturing the same in accordance with example implementations will become readily understood from detail descriptions that follow, with reference to the accompanying drawings.

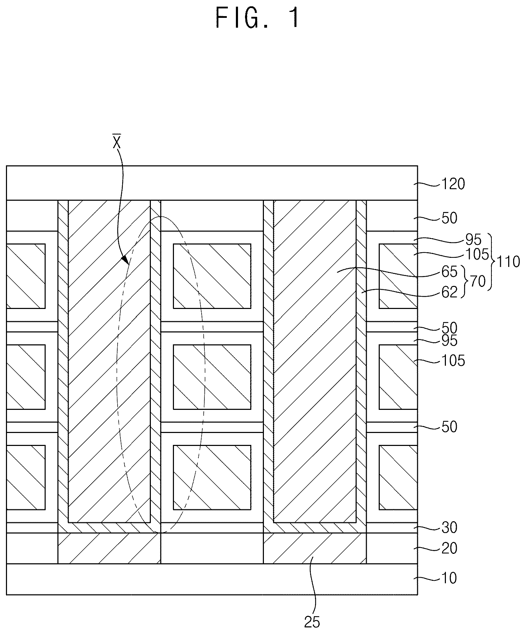

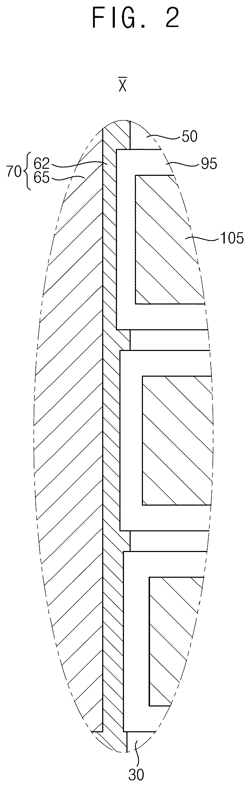

FIGS. 1 and 2 are cross-sectional views illustrating an example of a capacitor structure. FIG. 2 is an enlarged cross-sectional view of region X of FIG. 1.

Referring to FIGS. 1 and 2, the capacitor structure may include a capacitor 110, a support layer 50 and an upper plate electrode 120 on a substrate 10, and the capacitor 110 may include a lower electrode structure 70, a dielectric pattern 95 and an upper electrode 105.

The substrate 10 may include a semiconductor material, e.g., silicon, germanium, silicon-germanium, etc., or a III-V group compound semiconductor, e.g., GaP, GaAs, GaSb, etc. In some implementations, the substrate 10 may be a silicon-on-insulator (SOI) substrate or a germanium-on-insulator (GOI) substrate.

An insulating interlayer 20 may be disposed on the substrate 10, and a first conductive pattern 25 may be disposed in the insulating interlayer 20. The first conductive pattern 25 may include, e.g., a contact plug, a landing pad, etc., and a plurality of first conductive patterns 25 may be spaced apart from each other in a horizontal direction parallel to an upper surface of the substrate 10. The first conductive pattern 25 may include, e.g., a metal, a metal nitride, a metal silicide, doped polysilicon, etc. The insulating interlayer 20 may include, e.g., an oxide such as silicon oxide or a low-k dielectric material.

A first etch stop layer 30 may be disposed on the insulating interlayer 20. The first etch stop layer 30 may include an insulating nitride, e.g., silicon nitride, silicon boronitride, silicon carbonitride, etc.

The support layer 50 may be disposed on the first etch stop layer 30, and may have a shape of a flat plate including upper and lower surfaces extending in the horizontal direction. In some implementations, a plurality of support layers 50 may be spaced apart from each other in a vertical direction perpendicular to the upper surface of the substrate 10 on the first etch stop layer 30.

The support layer 50 may include an insulating nitride, e.g., silicon nitride, silicon boronitride, silicon carbonitride, etc.

The dielectric pattern 95 may be disposed between the first etch stop layer 30 and a lowermost one of the support layers 50 and between the support layers 50, and may contact a sidewall of the lower electrode structure 70. Additionally, the dielectric pattern 95 may also contact an upper surface of the first etch stop layer 30, a lower surface of an uppermost one of the support layers 50, and lower and upper surfaces of other ones of the support layers 50.

The dielectric pattern 95 may include an oxide of a metal having four valence electrons in its outermost shell such as hafnium, zirconium, or a high-k dielectric material.

A surface of the upper electrode 105 may be covered by the dielectric pattern 95, and the upper electrode 105 may be disposed between the first etch stop layer 30 and the lowermost one of the support layers 50 and between the support layers 50.

The upper electrode 105 may include a metal or a metal nitride, e.g., titanium, tantalum, tungsten, ruthenium, iridium, zirconium, hafnium, niobium, etc., or a metal nitride thereof.

Hereinafter, a portion of the dielectric pattern 95 between the first etch stop layer 30 and the lowermost one of the support layers 50 may be referred to as a first portion, a portion of the dielectric pattern 95 between the lowermost one of the support layers 50 and a first one of the support layers 50 that is disposed at a second level from above may be referred to a second portion, and a portion of the dielectric pattern 95 between the first one of the support layers 50 and the uppermost one of the support layers 50 may be referred to as a third portion.

In some implementations, the first to third portions of the dielectric pattern 95 may have a grain size that is substantially the same as or similar to each other, which may be referred to as a first grain size.

The lower electrode structure 70 may have a shape of a pillar extending in the vertical direction through the first etch stop layer 30 and the support layers 50, and may contact an upper surface of the first conductive pattern 25. However, the present disclosure is not limited thereto, and the lower electrode structure 70 may have a shape of a cup or a hollow cylinder.

In implementations, the lower electrode structure 70 includes a first lower electrode 65 and a second lower electrode 62 covering a sidewall and a lower surface of the first lower electrode 65.

The second lower electrode 62 may have a shape of, e.g., a cup, and may include a horizontal portion contacting the upper surface of the first conductive pattern 25 and a vertical portion on and contacting an edge of the horizontal portion and extending in the vertical direction. An inner sidewall of the vertical portion of the second lower electrode 62 may contact a sidewall of the first lower electrode 65, and an outer sidewall of the vertical portion of the second lower electrode 62 may contact sidewalls of the support layer 50 and the dielectric pattern 95.

A thickness in the horizontal direction of the vertical portion of the second lower electrode 62 may vary in the vertical direction.

In some implementations, a first portion of the second lower electrode 62 overlapping the support layer 50 or the first etch stop layer 30 in the horizontal direction may have a first thickness in the horizontal direction, a second portion of the second lower electrode 62 overlapping the first portion of the dielectric pattern 95 in the horizontal direction may have a second thickness in the horizontal direction that is less than the first thickness, a third portion of the second lower electrode 62 overlapping the second portion of the dielectric pattern 95 in the horizontal direction may have a third thickness in the horizontal direction that is less than the second thickness, and a fourth portion of the second lower electrode 62 overlapping the third portion of the dielectric pattern 95 in the horizontal direction may have a fourth thickness in the horizontal direction that is less than the third thickness.

In some implementations, the thickness in the horizontal direction of each of the second to fourth portions of the second lower electrode 62 may gradually decrease from a bottom toward a top thereof in the vertical direction.

In some implementations, the inner sidewall of the vertical portion of the second lower electrode 62 may extend in a straight line in the vertical direction, and first to third recesses may be formed on an outer sidewall of the vertical portion of the second lower electrode 62 to correspond to the first to third portions, respectively, of the dielectric pattern 95. The first recess may have a first depth in the horizontal direction, the second recess may have a second depth in the horizontal direction greater than the first depth, and the third recess may have a third depth in the horizontal direction greater than the second depth.

The second lower electrode 62 may include an alloy of a first metal and a second metal, or a nitride of the alloy. Each of the first and second metals may include, e.g., titanium, tantalum, tungsten, ruthenium, iridium, zirconium, hafnium, niobium, etc.

In some implementations, a content ratio, e.g., a weight ratio between the first and second metals in the second lower electrode 62 is substantially constant in the vertical direction even though the thickness in the horizontal direction of the vertical portion of the second lower electrode 62 varies in the vertical direction.

The first lower electrode 65 may be disposed on the second lower electrode 62, and may extend in the vertical direction. The first lower electrode 65 may have a substantially constant width in the horizontal direction. In some implementations, the first lower electrode 65 may include a material having a stiffness greater than a stiffness of the second lower electrode 62, e.g., a metal silicon nitride such as titanium silicon nitride or a metal nitride such as titanium aluminum nitride, etc.

In some implementations, a thickness in the horizontal direction of the lower electrode structure 70 may be equal to or greater than about 200Å, and a thickness in the horizontal direction of the vertical portion of the second lower electrode 62 may be in a range of about 1Å to about 100Å.

If the lower electrode structure 70 has a shape of a cup, the first lower electrode 65 may also have a shape of a cup, and a filling pattern including a semiconductor material, e.g., amorphous silicon or an insulting material may be disposed in an inner space that may be defined by the first lower electrode 65.

The upper plate electrode 120 may be disposed on the lower electrode structure 70 and the uppermost one of the support layers 50, and may include, e.g., doped silicon-germanium.

The lower electrode structure 70 included in the capacitor structure according to example implementations may include the first lower electrode 65 and the second lower electrode 62 on the sidewall and the lower surface of the first lower electrode 65, and the thickness in the horizontal direction of the second lower electrode 62 may not be constant but varies in the vertical direction.

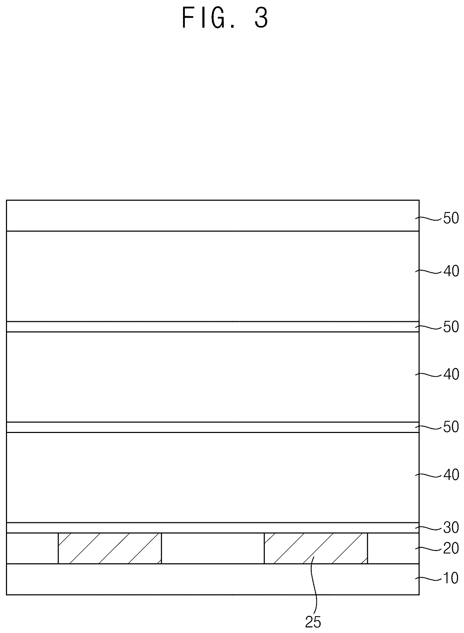

According to implementations of the present disclosure, the second lower electrode 62 may have a single-layered structure including the same conductive material. Thus, when compared to related art in which a composite layer having first and second layers including different conductive materials, and the first layer has a constant thickness but the second layer has a varying thickness, the lower electrode structure 70 including the second lower electrode 62 may have a uniform capacitance in the vertical direction, which is explained in detail below with reference to FIGS. 3 to 11.

The first lower electrode 65 may include a material having a stiffness greater than that of the second lower electrode 62. Thus, if a content ratio, e.g., a weight ratio or a volume ration of the second lower electrode 62 in the lower electrode structure 70 decreases, a content ratio of the first lower electrode 65 having the relatively high stiffness may increase so that a total stiffness of the lower electrode structure 70 may be improved.

FIGS. 3, 4, 5, 6, 7, 8, and 9 are cross-sectional views illustrating an example of a method of forming a capacitor structure.

Referring to FIG. 3, an insulating interlayer 20 may be formed on a substrate 10, a first conductive pattern 25 may be formed through the insulating interlayer 20, a first etch stop layer 30 may be formed on the insulating interlayer 20 and the first conductive pattern 25, and a mold layer 40 and a support layer 50 may be alternately and repeatedly stacked on the first etch stop layer 30.

In some implementations, a plurality of first conductive patterns 25 may be formed to be spaced apart from each other in a horizontal direction parallel to an upper surface of the substrate 10.

The mold layer 40 may include an oxide, e.g., silicon oxide or a low-k dielectric material.

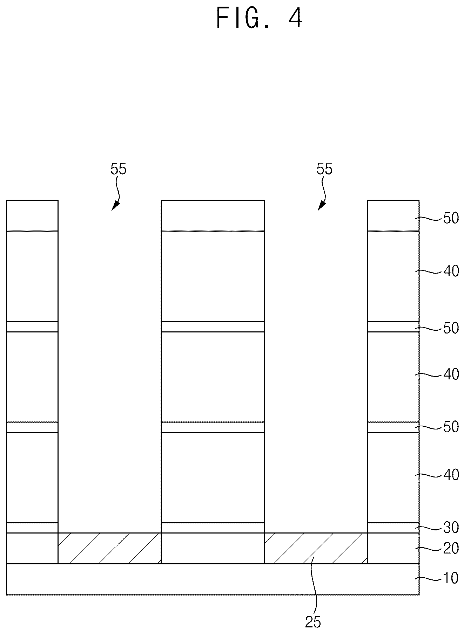

Referring to FIG. 4, a first opening 55 may be formed through the support layer 50, the mold layer 40 and the first etch stop layer 30 to expose an upper surface of each of the first conductive patterns 25.

In some implementations, the first opening 55 may be formed by forming an etching mask on an uppermost one of the support layers 50 and performing a dry etching process using the etching mask.

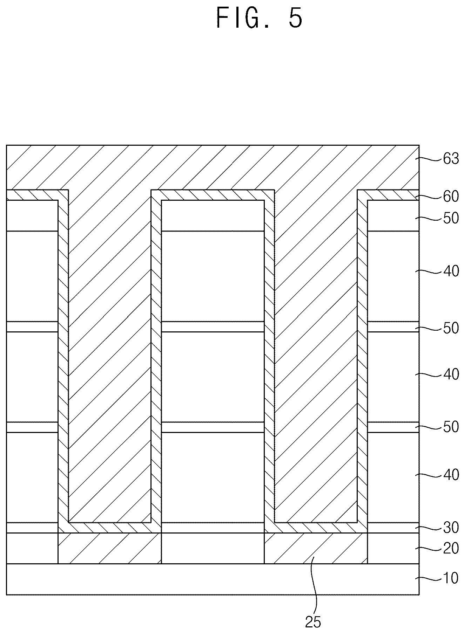

Referring to FIG. 5, a second lower electrode layer 60 may be formed on the upper surface of the first conductive pattern 25 exposed by the first opening 55, a sidewall of the first opening 55 and an upper surface of the uppermost one of the support layers 50.

In some implementations, the second lower electrode layer 60 may be formed by a deposition process using, e.g., a first source gas of a first metal, a second source gas of a second metal, and/or a nitrogen source gas. Thus, the second lower electrode 60 may include an alloy of the first metal and the second metal, or a nitride of the alloy.

In some implementations, the deposition process may include an atomic layer deposition (ALD) process, and thus the second lower electrode layer 60 may be conformally formed.

A first lower electrode layer 63 may be formed on the second lower electrode layer 60 to fill the first opening 55. In some implementations, the first lower electrode layer 63 may include a metal silicon nitride, e.g., titanium silicon nitride.

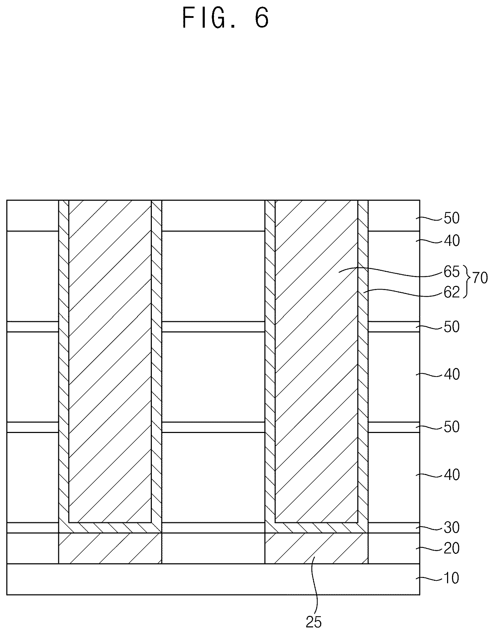

Referring to FIG. 6, a planarization process may be performed on the first and second lower electrode layers 63 and 60 until the upper surface of the uppermost one of the support layers 50 is exposed, and thus first and second lower electrodes 65 and 62 may be formed.

The planarization process may include a chemical mechanical polishing (CMP) process and/or an etch back process, and the first and second lower electrodes 65 and 62 may collectively form a lower electrode structure 70.

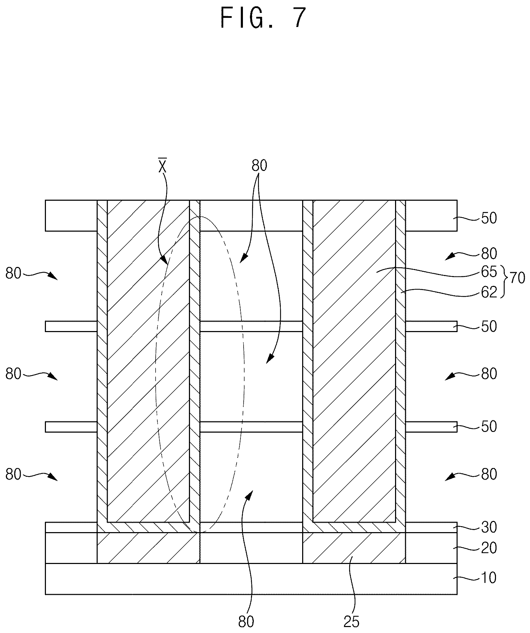

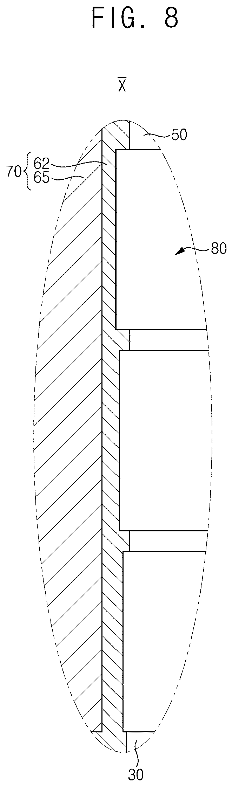

Referring to FIGS. 7 and 8, the mold layer 40 may be partially removed by, e.g., a wet etching process to form a third opening 80 exposing a sidewall of the second lower electrode 62, an upper surface of the first etch stop layer 30 and a surface of each of the support layers 50.

During the wet etching process, a lateral portion of the second lower electrode 62 exposed by the third opening 80 may also be partially removed.

In some implementations, the third opening 80 may be formed by partially removing the support layer 50 and the mold layer 40 through a dry etching process to form a second opening exposing the upper surface of the first etch stop layer 30, and performing a wet etching process through the second opening to remove the mold layer 40.

An etching solution used in the wet etching process may be provided from a top of the second opening, and thus an exposure time of the lateral portion of the second lower electrode 62 to the etching solution may decrease from a top toward a bottom thereof in the vertical direction so that an amount of etching of the lateral portion of the second lower electrode 62 may gradually decrease from the top toward the bottom thereof.

In some implementations, an amount of etching of a portion of the lateral portion of the second lower electrode 62 between the uppermost one of the support layers 50 and a first one of the support layers 50 at a second level from above may be greater than an amount of etching of a portion of the lateral portion of the second lower electrode 62 between the first one of the support layers 50 and a lowermost one of the support layers 50, and the amount of etching of the portion of the lateral portion of the second lower electrode 62 between the first one of the support layers 50 and the lowermost one of the support layers 50 may be greater than an amount of etching of a portion of the lateral portion of the second lower electrode 62 between the lowermost one of the support layers 50 and the first etch stop layer 30.

Alternatively, the third opening 80 may be formed by partially removing the uppermost one of the support layers 50 through a first dry etching process to partially expose the mold layer 40, performing a first wet etching process to remove a portion of the mold layer 40 on the first one of the support layers 50 at the second level from above, partially removing the first one of the support layers 50 through a second dry etching process to partially expose the mold layer 40, performing a second wet etching process to remove a portion of the mold layer 40 on the lowermost one of the support layers 50, partially removing the lowermost one of the support layers 50 through a third dry etching process to partially expose the mold layer 40, and performing a third wet etching process to remove a portion of the mold layer 40 on the first etch stop layer 30.

An exposure time of the lateral portion of the second lower electrode 62 to the etching solution may decrease from a top toward a bottom thereof in the vertical direction so that an amount of etching of a portion of the lateral portion of the second lower electrode 62 between neighboring ones of the support layers 50 in the vertical direction and an amount of etching of a portion of the lateral portion of the second lower electrode 62 between the lowermost one of the support layers 50 and the first etch stop layer 30 may gradually decrease from a top toward a bottom thereof.

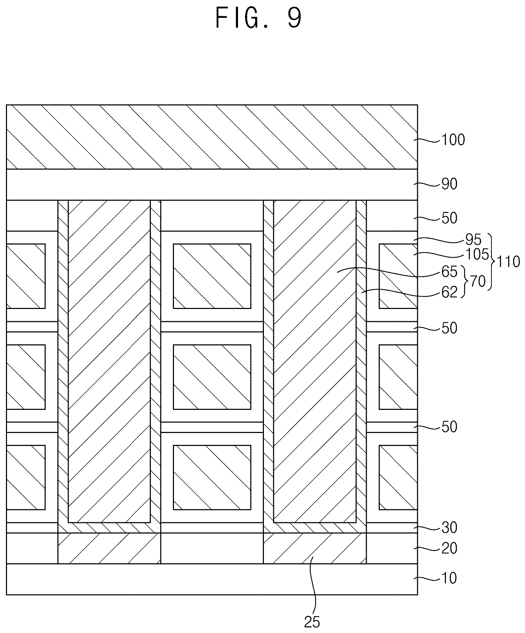

Referring to FIG. 9, a dielectric layer 90 may be formed on a sidewall of the lower electrode structure 70 exposed by the third opening 80, the upper surface of the first etch stop layer 30 and the surface of each of the support layers 50, and an upper electrode layer 100 may be formed on the dielectric layer 90 to fill the third opening 80.

The dielectric layer 90 may include, e.g., hafnium oxide, zirconium oxide, or a compound thereof.

The dielectric layer 90 and the upper electrode layer 100 may also be formed on an upper surface of the lower electrode structure 70 and the upper surface of the uppermost one of the support layers 50.

Referring to FIGS. 1 and 2 again, portions of the dielectric layer 90 and the upper electrode layer 100 on the upper surface of the lower electrode structure 70 and the uppermost one of the support layers 50 may be removed.

Thus, the dielectric layer 90 and the upper electrode layer 100 may remain as a dielectric pattern 95 and an upper electrode 105, respectively, in the third opening 80.

The lower electrode structure 70, the dielectric pattern 95 and the upper electrode 105 may collectively form a capacitor 110.

An upper plate electrode 120 may be further formed on the capacitor 110 to complete the formation of the capacitor structure.

As illustrated above, the mold layer 40 may be removed by a wet etching process to form the third opening 80 exposing the sidewall of the second lower electrode 62, the upper surface of the first etch stop layer 30 and the surface of the support layers 50, and during the wet etching process, the lateral portion of the second lower electrode 62 having a single-layered structure may be partially removed so that a thickness of a portion of the lateral portion of the second lower electrode 62 exposed by the third opening 80 may be reduced.

In related art where the second lower electrode 62 has a multi-layered structure, e.g., a double-layered structure having first and second layers including first and second conductive materials, respectively, during the wet etching process for forming the third opening 80, the second layer is partially removed while the first layer covered by the second layer is not removed so that a content ratio of the first and second conductive materials may be different between a portion of the second lower electrode 62 from which the second layer is relatively more removed and a portion of the second lower electrode 62 from which the second layer is relatively less removed. Thus, the lower electrode structure 70 including the second lower electrode 62 may have a varying capacitance in the vertical direction instead of having a uniform capacitance.

In contrast, according to implementations of the present disclosure, the second lower electrode 62 may have a single-layered structure including the same conductive material, and thus, even though the lateral portion of the second lower electrode 62 is partially removed by the wet etching process for forming the third opening 80 so that the second lower electrode 62 may have a varying thickness in the vertical direction, content ratios of the conductive materials included in respective portions of the second lower electrode 62 may be substantially the same as each other. Accordingly, the lower electrode structure 70 including the second lower electrode 62 may have a uniform capacitance in the vertical direction.

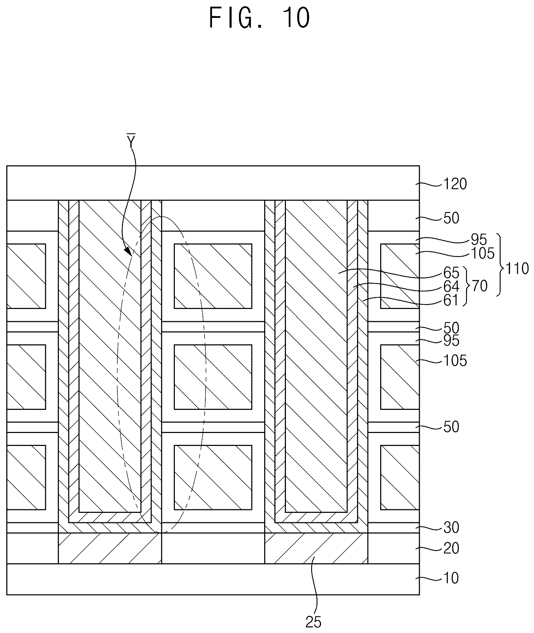

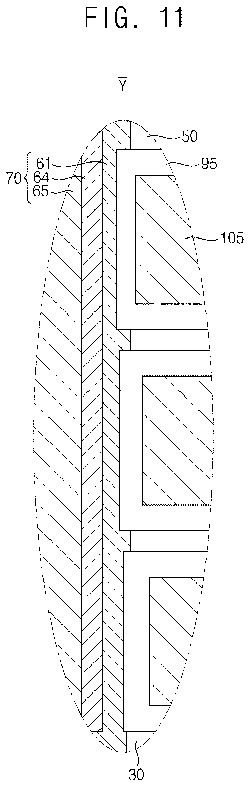

FIGS. 10 and 11 are cross-sectional views illustrating a comparative example of a capacitor structure. FIG. 11 is an enlarged cross-sectional view of region Y of FIG. 10. This capacitor structure may be substantially the same as or similar to that of FIGS. 1 and 2, except for the lower electrode structure 70, and thus repeated explanations are omitted herein.

Referring to FIGS. 10 and 11, the lower electrode structure 70 may include a first lower electrode 65, a third lower electrode 64 covering a lower surface and a sidewall of the first lower electrode 65, and a fourth lower electrode 61 covering a surface of the third lower electrode 64.

The third lower electrode 64 may conformally cover the lower surface and the sidewall of the first lower electrode 65, and may include a nitride of a third metal, e.g., titanium.

The fourth lower electrode 61 may include a horizontal portion contacting the upper surface of the first conductive pattern 25, and a vertical portion on and contacting an edge of the horizontal portion and extending in the vertical direction. Like the second lower electrode 62, a thickness in the horizontal direction of the vertical portion of the fourth lower electrode 61 may vary in the vertical direction. The fourth lower electrode 61 may include a nitride of a fourth metal, e.g., niobium.

As the thickness of the fourth lower electrode 61 varies in the vertical direction, a content ratio between the third and fourth metals included in the third and fourth lower electrodes 64 and 61, respectively, which are disposed between the first lower electrode 65 and the dielectric pattern 95, may vary in the vertical direction. That is, a content ratio of the fourth metal included in the fourth lower electrode 61 may relatively decrease in a portion of the lower electrode structure 70 where the thickness of the fourth lower electrode 61 is relatively thin, while the content ratio of the fourth metal included in the fourth lower electrode 61 may relatively increase in a portion of the lower electrode structure 70 where the thickness of the fourth lower electrode 61 is relatively thick.

Thus, a capacitance of the lower electrode structure 70 may not be uniform but varying in the vertical direction.

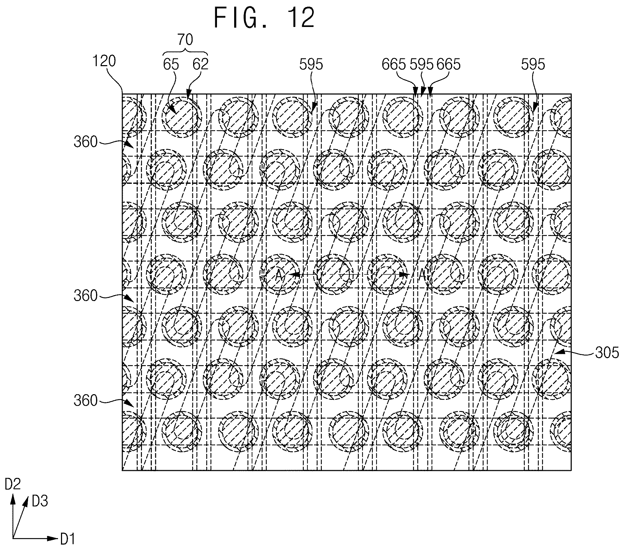

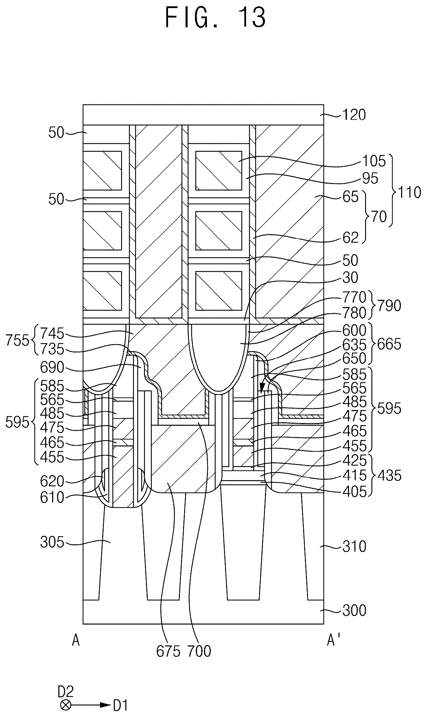

FIG. 12 is a plan view illustrating an example of a semiconductor device according to implementations of the present disclosure, and FIG. 13 is a cross-sectional view taken along line A-A' of FIG. 12.

This semiconductor device may be a DRAM device to which the capacitor structure of FIGS. 1 and 2 is applied, and thus repeated explanations on the capacitor structure are omitted herein.

Hereinafter, two directions substantially perpendicular to each other among horizontal directions that are substantially parallel to an upper surface of a substrate 300 may be referred to as first and second directions D1 and D2, and a direction among the horizontal direction, which may have an acute angle with respect to the first and second directions D1 and D2, may be referred to as a third direction D3. A direction substantially perpendicular to the upper surface of the substrate 300 may be referred to as a vertical direction.

The semiconductor device may include an active pattern 305, a gate structure 360, a bit line structure 595, a contact plug structure and the capacitor structure on a substrate 300.

Additionally, the semiconductor device may further include an isolation pattern 310, a spacer structure 665, a fourth spacer 690, a second capping pattern 685, first and second insulation pattern structures 435 and 790, and fourth and fifth insulation patterns 610 and 620.

The substrate 300 may include a semiconductor material, e.g., silicon, germanium, silicon-germanium, etc., or a III-V group compound semiconductor, e.g., GaP, GaAs, GaSb, etc.

The active pattern 305 may extend in the third direction D3, and a plurality of active patterns 305 may be spaced apart from each other in the first and second directions D1 and D2. The isolation pattern 310 may cover a sidewall of the active pattern 305. The active pattern 305 may include a material substantially the same as the substrate 300, and the isolation pattern 310 may include an oxide, e.g., silicon oxide.

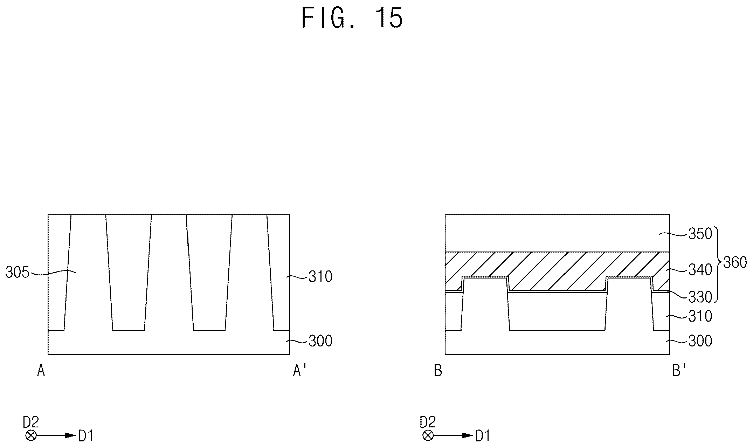

Referring to FIGS. 12 and 13 together with FIG. 15, the gate structure 360 may be disposed in a second recess extending through upper portions of the active pattern 305 and the isolation pattern 310 in the first direction D1. The gate structure 360 may include a gate insulation pattern 330 on a bottom and a sidewall of the second recess, a gate electrode 340 on a portion of the gate insulation pattern 330 on the bottom and a lower sidewall of the second recess, and a gate mask 350 on the gate electrode 340 in an upper portion of the second recess.

The gate insulation pattern 330 may include an oxide, e.g., silicon oxide, the gate electrode 340 may include a conductive material, e.g., a metal, a metal nitride, a metal silicide, etc., and the gate mask 350 may include an insulating nitride, e.g., silicon nitride.

In some implementations, the gate structure 360 may extend in the first direction D1, and a plurality of gate structures 360 may be spaced apart from each other in the second direction D2.

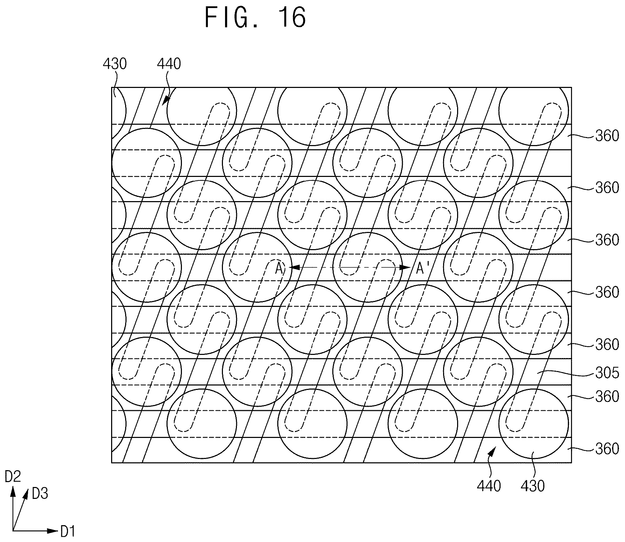

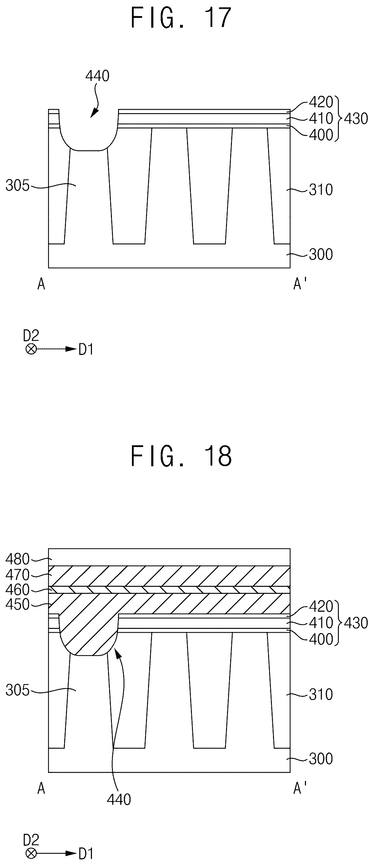

Referring to FIGS. 12 and 13 together with FIGS. 16 and 17, a fourth opening 440 may be formed through an insulation layer structure 430 and expose upper surfaces of the active pattern 305, the isolation pattern 310 and the gate mask 350 of the gate structure 360, and an upper surface of a central portion in the third direction D3 of the active pattern 305 may be exposed by the fourth opening 440.

In some implementations, a bottom of the fourth opening 440 may be wider than the upper surface of the active pattern 305 exposed by the fourth opening 440. Thus, the fourth opening 440 may also expose an upper surface of a portion of the isolation pattern 310 adjacent to the active pattern 305. The fourth opening 440 may also extend through upper portions of the active pattern 305 and the isolation pattern 310, and thus the bottom of the fourth opening 440 may be lower than an upper surface of a portion of the active pattern 305 in which the fourth opening 440 is not formed, e.g., each of opposite end portions in the third direction D3 of the active pattern 305.

The bit line structure 595 may include a first conductive pattern 455, a first barrier pattern 465, a second conductive pattern 475, a first mask 485, a second etch stop pattern 565 and a first capping pattern 585 sequentially stacked in the vertical direction on the fourth opening 440 or on the first insulation pattern structure 435. The first conductive pattern 455, the first barrier pattern 465 and the second conductive pattern 475 may collectively form a conductive structure, and the first mask 485, the second etch stop pattern 565 and the first capping pattern 585 may collectively form an insulation structure.

The first conductive pattern 455 may include, e.g., doped polysilicon, the first barrier pattern 465 may include a metal nitride, e.g., titanium nitride, or a metal silicon nitride, e.g., titanium silicon nitride, the second conductive pattern 475 may include a metal, e.g., tungsten, and each of the first mask 485, the second etch stop pattern 565 and the first capping pattern 585 may include an insulating nitride, e.g., silicon nitride.

In some implementations, the bit line structure 595 may extend in the second direction D2 on the substrate 300, and a plurality of bit line structures 595 may be spaced apart from each other in the first direction D1.

The fourth and fifth insulation patterns 610 and 620 may be disposed on the fourth opening 440, and may contact a lower sidewall of the bit line structure 595. The fourth insulation pattern 610 may include an oxide, e.g., silicon oxide, and the fifth insulation pattern 620 may include an insulating nitride, e.g., silicon nitride.

The first insulation pattern structure 435 may be disposed under the bit line structure 595 on the active pattern 305 and the isolation pattern 310, and may include first, second and third insulation patterns 405, 415 and 425 sequentially stacked in the vertical direction. The first and third insulation patterns 405 and 425 may include an oxide, e.g., silicon oxide, and the second insulation pattern 415 may include an insulating nitride, e.g., silicon nitride.

The contact plug structure may include a lower contact plug 675, a metal silicide pattern 700 and an upper contact plug 755 sequentially stacked on the active pattern 305 and the isolation pattern 310 in the vertical direction.

The lower contact plug 675 may contact the upper surface of each of opposite end portions in the third direction D3 of the active pattern 305. In some implementations, a plurality of lower contact plugs 675 may be spaced apart from each other in the second direction D2 between neighboring ones of the bit line structures 595 in the first direction D1, and the second capping pattern 685 may be disposed between neighboring ones of the lower contact plugs 675 in the second direction D2. The second capping pattern 685 may include an insulating nitride, e.g., silicon nitride.

The lower contact plug 675 may include, e.g., doped polysilicon, and the metal silicide pattern 700 may include, e.g., titanium silicide, cobalt silicide, nickel silicide, etc.

The upper contact plug 755 may include a second metal pattern 745 and a second barrier pattern 735 covering a lower surface of the second metal pattern 745. The second metal pattern 745 may include a metal, e.g., tungsten, and the second barrier pattern 735 may include a metal nitride, e.g., titanium nitride.

In some implementations, a plurality of upper contact plugs 755 may be spaced apart from each other in each of the first and second directions D1 and D2, and may be arranged in a honeycomb pattern or a lattice pattern in a plan view. Each of the upper contact plugs 755 may have a shape of, e.g., a circle, an ellipse or a polygon in a plan view.

The spacer structure 665 may include a first spacer 600 covering a sidewall of the bit line structure 595 and a sidewall of the third insulation pattern 425, an air spacer 635 on a lower outer sidewall of the first spacer 600, and a third spacer 650 covering an outer sidewall of the air spacer 635, a sidewall of the first insulation pattern structure 435 and upper surfaces of the fourth and fifth insulation patterns 610 and 620.

Each of the first and third spacers 600 and 650 may include an insulating nitride, e.g., silicon nitride, and the air spacer 895 may include air.

The fourth spacer 690 may be disposed on an outer sidewall of a portion of the first spacer 600 on an upper sidewall of the bit line structure 595, and may cover a top of the air spacer 635 and an upper surface of the third spacer 650. The fourth spacer 690 may include an insulating nitride, e.g., silicon nitride.

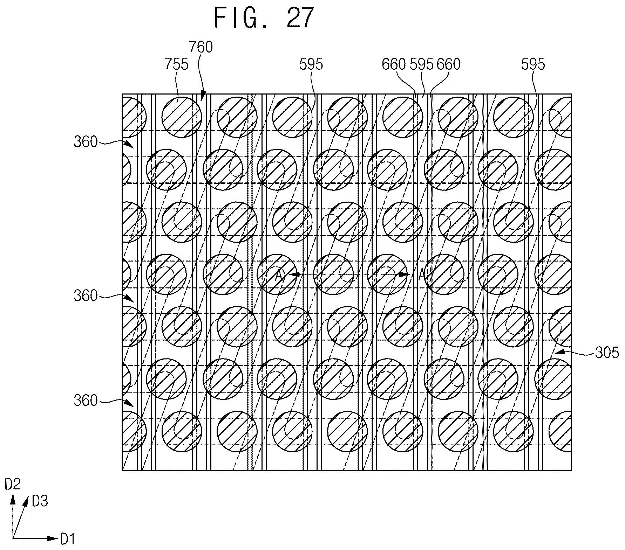

Referring to FIGS. 12 and 13 together with FIGS. 27 to 29, the second insulation pattern structure 790 may include a sixth insulation pattern 770 and a seventh insulation pattern 780. The sixth insulation pattern 770 may be disposed on an inner wall of a ninth opening 760 extending through the upper contact plug 755, a portion of the insulation structure included in the bit line structure 595, and portions of the first, third and fourth spacers 600, 650 and 690 to surround the upper contact plug 755 in a plan view. The seventh insulation pattern 780 may be disposed on the sixth insulation pattern 770, and may fill a remaining portion of the ninth opening 760. The top of the air spacer 635 may be closed by the sixth insulation pattern 770.

The sixth and seventh insulation patterns 770 and 780 may include an insulating nitride, e.g., silicon nitride.

The first etch stop layer 30 may be disposed on the sixth and seventh insulation patterns 770 and 780, the upper contact plug 755 and the second capping pattern 685.

The capacitor 110 may contact an upper surface of the upper contact plug 775.

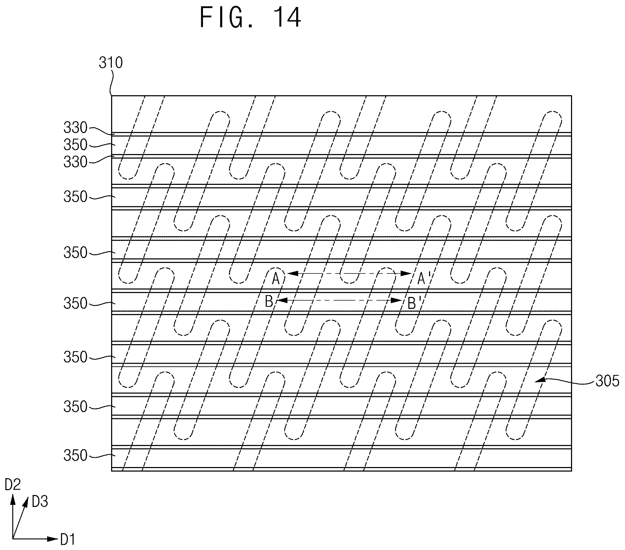

FIGS. 14, 15, 16, 17, 18, 19, 20, 21, 22, 23, 24, 25, 26, 27, 28, and 29 are plan views and cross-sectional views illustrating an example of a method of manufacturing a semiconductor device. Particularly, FIGS. 14, 16, 19, 23 and 27 are the plan views, FIG. 15 includes cross-sectional views taken along lines A-A' and B-B', respectively, of FIG. 14, and FIGS. 17-18, 20-22, 24-26 and 28-29 are cross-sectional views taken along lines A-A' of corresponding plan views, respectively.

This method may be an application of the forming method illustrated with reference to FIGS. 3 to 9 and FIGS. 1 and 2 to a method of manufacturing a DRAM device, and repeated explanations of the method of forming the capacitor structure are omitted herein.

Referring to FIGS. 14 and 15, an upper portion of a substrate 300 may be removed to form a first recess, and an isolation pattern 310 may be formed in the first recess.

As the first recess is formed on the substrate 300, an active pattern 305 may be defined on the substrate 300, and a sidewall of the active pattern 305 may be covered by the isolation pattern 310.

The active pattern 305 and the isolation pattern 310 on the substrate 300 may be partially etched to form a second recess extending in the first direction D1, and a gate structure 360 may be formed in the second recess. In some implementations, the gate structure 360 may extend in the first direction D1, and a plurality of gate structures 360 may be spaced apart from each other in the second direction D2.

Referring to FIGS. 16 and 17, an insulation layer structure 430 may be formed on the active pattern 305, the isolation pattern 310 and the gate structure 360. The insulation layer structure 430 may include first, second and third insulation layers 400, 410 and 420 sequentially stacked in the vertical direction.

The insulation layer structure 430 may be patterned, and the active pattern 305, the isolation pattern 310 and the gate mask 350 of the gate structure 360 may be partially etched by an etching process using the patterned insulation layer structure 430 as an etching mask to form a fourth opening 440. In some implementations, the insulation layer structure 430 remaining after the etching process may have a shape of, e.g., a circle or an ellipse in a plan view, and a plurality of insulation layer structures 430 may be spaced apart from each other in the first and second directions D1 and D2. Each of the insulation layer structures 430 may overlap edge portions in the third direction D3 of neighboring active patterns 305, respectively.

Referring to FIG. 18, a first conductive layer 450, a first barrier layer 460, a second conductive layer 470 and a first mask layer 480 may be sequentially stacked on the insulation layer structure 430, and the active pattern 305, the isolation pattern 310 and the gate structure 360 exposed by the fourth opening 440, which may collectively form a conductive layer structure. The first conductive layer 450 may fill the fourth opening 440.

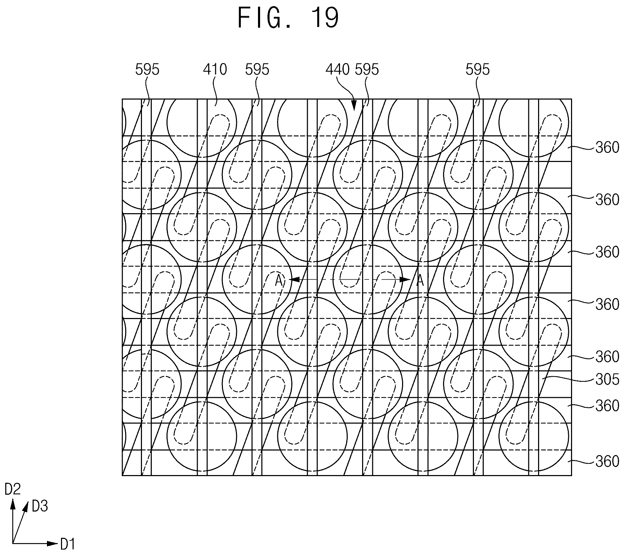

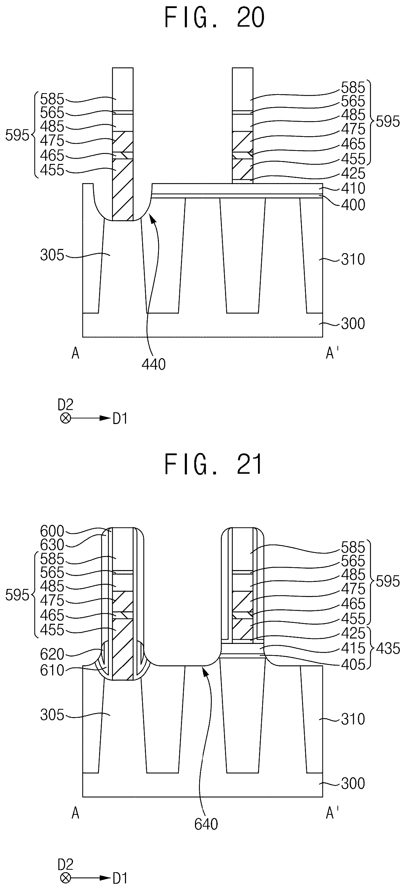

Referring to FIGS. 19 and 20, a second etch stop layer and a first capping layer may be sequentially stacked on the conductive layer structure, and the first capping layer may be etched to form a first capping pattern 585. The second etch stop layer, the first mask layer 480, the second conductive layer 470, the first barrier layer 460 and the first conductive layer 450 may be sequentially etched by an etching process using the first capping pattern 585 as an etching mask.

In some implementations, the first capping pattern 585 may extend in the second direction D2, and a plurality of first capping patterns 585 may be spaced apart from each other in the first direction D1.

By the etching process, a first conductive pattern 455, a first barrier pattern 465, a second conductive pattern 475, a first mask 485, a second etch stop pattern 565 and the first capping pattern 585 may be sequentially stacked on the fourth opening 440, and a third insulation pattern 425, the first conductive pattern 455, the first barrier pattern 465, the second conductive pattern 475, the first mask 485, the second etch stop pattern 565 and the first capping pattern 585 may be sequentially stacked on the second insulation layer 410 of the insulation layer structure 430 at an outside of the fourth opening 440.

Hereinafter, the first conductive pattern 455, the first barrier pattern 465, the second conductive pattern 475, the first mask 485, the second etch stop pattern 565 and the first capping pattern 585 sequentially stacked may be referred to as a bit line structure 595. The first conductive pattern 455, the first barrier pattern 465 and the second conductive pattern 475 may collectively form a conductive structure, and the first mask 485, the second etch stop pattern 565 and the first capping pattern 585 may collectively form an insulation structure. In some implementations, the bit line structure 595 may extend in the second direction D2 on the substrate 300, and a plurality of bit line structures 595 may be spaced apart from each other in the first direction D1.

Referring to FIG. 21, a first spacer layer may be formed on the substrate 300 having the bit line structure 595 thereon, and fourth and fifth insulation layers may be sequentially formed on the first spacer layer.

The first spacer layer may also cover a sidewall of the third insulation pattern 425 under a portion of the bit line structure 595 on the second insulation layer 410, and the fifth insulation layer may fill a remaining portion of the fourth opening 440.

The fourth and fifth insulation layers may be etched by an etching process. In some implementations, the etching process may be performed by a wet etching process using an etching solution, e.g., H₂PO₃, SC1, HF, etc., and portions of the fourth and fifth insulation layers at the outside of the fourth opening 440 may be removed. Thus, a portion of the first spacer layer at the outside of the fourth opening 440 may be exposed, and portions of the fourth and fifth insulation layers in the fourth opening 440 may form fourth and fifth insulation patterns 610 and 620, respectively.

A second spacer layer may be formed on the exposed portion of the first spacer layer and the fourth and fifth insulation patterns 610 and 620 in the fourth opening 440, and may be anisotropically etched to form a second spacer 630 on the exposed portion of the first spacer and the fourth and fifth insulation patterns 610 and 620 to cover a sidewall of the bit line structure 595.

A dry etching process may be performed using the first capping pattern 585 and the second spacer 630 as an etching mask to form a fifth opening 640 exposing an upper surface of the active pattern 305, and upper surfaces of the isolation pattern 310 and the gate mask 350 may also be exposed by the fifth opening 640.

By the dry etching process, a portion of the first spacer layer on the first capping pattern 585 and the second insulation layer 410 may be removed, and thus a first spacer 600 covering a sidewall of the bit line structure 595 may be formed. Additionally, by the dry etching process, the first and second insulation layers 400 and 410 may also be partially etched so that first and second insulation patterns 405 and 415 may remain under the bit line structure 595. The first to third insulation patterns 405, 415 and 425 sequentially stacked under the bit line structure 595 may collectively form a first insulation pattern structure 435.

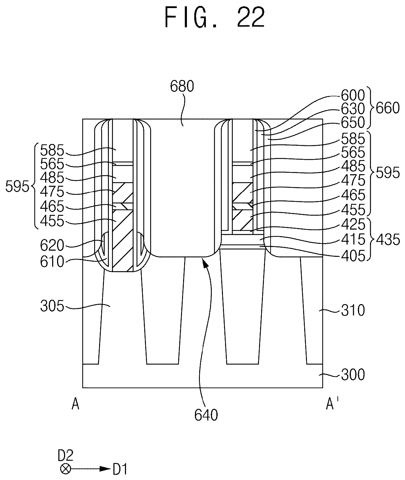

Referring to FIG. 22, a third spacer layer may be formed on an upper surface of the first capping pattern 585, an outer sidewall of the second spacer 630, upper surfaces of the fourth and fifth insulation patterns 610 and 620, and the upper surfaces of the active pattern 305, the isolation pattern 310 and the gate mask 350 exposed by the fifth opening 640, and may be anisotropically etched to form a third spacer 650 on the sidewall of the bit line structure 595.

The first, second and third spacers 600, 630 and 650 sequentially stacked on the sidewall of the bit line structure 595 may collectively form a preliminary spacer structure 660.

A sacrificial layer may be formed on the substrate 300 to fill the fifth opening 640, and may be planarized until the upper surface of the first capping pattern 585 is exposed to form a sacrificial pattern 680 in the fifth opening 640.

In some implementations, the sacrificial pattern 680 may extend in the second direction D2, and a plurality of sacrificial patterns 680 may be spaced apart from each other in the first direction D1 by the bit line structures 595. The sacrificial pattern 680 may include an oxide, e.g., silicon oxide.

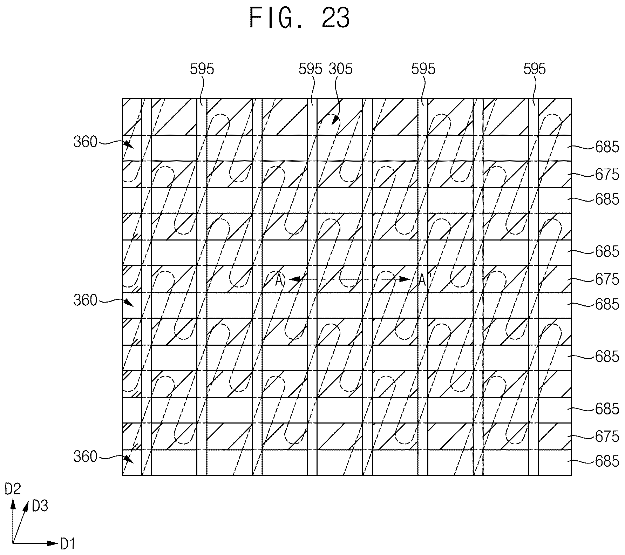

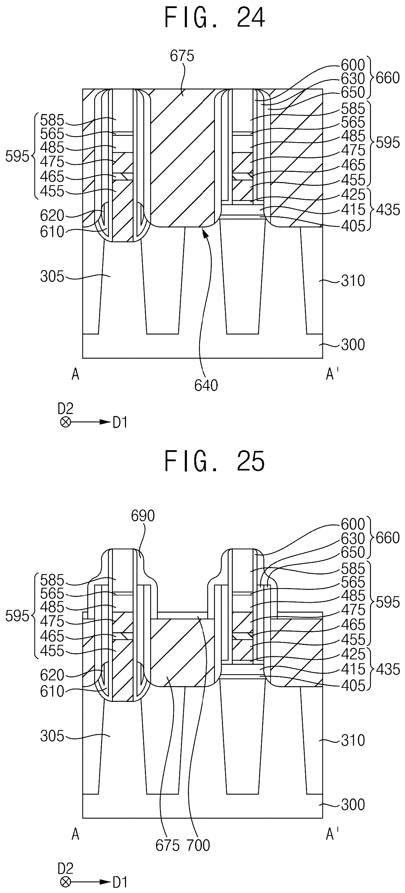

Referring to FIGS. 23 and 24, a second mask including a plurality of sixth openings, each of which may extend in the first direction D1, spaced apart from each other in the second direction D2 may be formed on the first capping pattern 585, the sacrificial pattern 680 and the preliminary spacer structure 660, and the sacrificial pattern 680 may be etched by an etching process using the second mask as an etching mask.

In some implementations, each of the sixth openings may overlap in the vertical direction an area between the gate structures 360. By the etching process, a seventh opening exposing upper surfaces of the active pattern 305 and the isolation pattern 310 may be formed between the bit line structures 595.

After removing the second mask, a lower contact plug layer may be formed to fill the seventh opening, and may be planarized until upper surfaces of the first capping pattern 585, the sacrificial pattern 680 and the preliminary spacer structure 660 are exposed. Thus, the lower contact plug layer may be divided into a plurality of lower contact plugs 675 spaced apart from each other in the second direction D2 between the bit line structures 595. Additionally, the sacrificial pattern 680 extending in the second direction D2 between the bit line structures 595 may be divided into a plurality of parts spaced apart from each other in the second direction D2 by the lower contact plugs 675.

The sacrificial pattern 680 may be removed to form an eighth opening, and a second capping pattern 685 may be formed in the eighth opening. In some implementations, the second capping pattern 685 may overlap the gate structure 360 in the vertical direction.

Referring to FIG. 25, an upper portion of the lower contact plug 675 may be removed to expose an upper portion of the preliminary spacer structure 660 on the sidewall of the bit line structure 595, and upper portions of the second and third spacers 630 and 650 of the preliminary spacer structure 660 may be removed.

An upper portion of the lower contact plug 675 may be further removed. Thus, an upper surface of the lower contact plug 675 may be lower than upper surfaces of the second and third spacers 630 and 650.

A fourth spacer layer may be formed on the bit line structure 595, the preliminary spacer structure 660, the second capping pattern 685 and the lower contact plug 675, and may be anisotropically etched to form a fourth spacer 690 covering an upper portion of the preliminary spacer structure 660 on each of opposite sidewalls in the first direction D1 of the bit line structure 595, and thus an upper surface of the lower contact plug 675 may be exposed.

A metal silicide pattern 700 may be formed on the upper surface of the lower contact plug 675. In some implementations, the metal silicide pattern 700 may be formed by forming a first metal layer on the first and second capping patterns 585 and 685, the fourth spacer 690 and the lower contact plug 675, performing a heat treatment process, and removing an unreacted portion of the first metal layer.

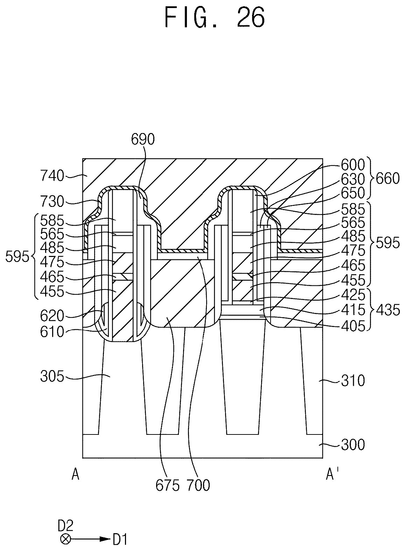

Referring to FIG. 26, a second barrier layer 730 may be formed on the first and second capping patterns 585 and 685, the fourth spacer 690, the metal silicide pattern 700 and the lower contact plug 675, and a second metal layer 740 may be formed on the second barrier layer 730 to fill a space between the bit line structures 595.

A planarization process may be further performed on an upper portion of the second metal layer 740. The planarization process may include a CMP process and/or an etch back process.

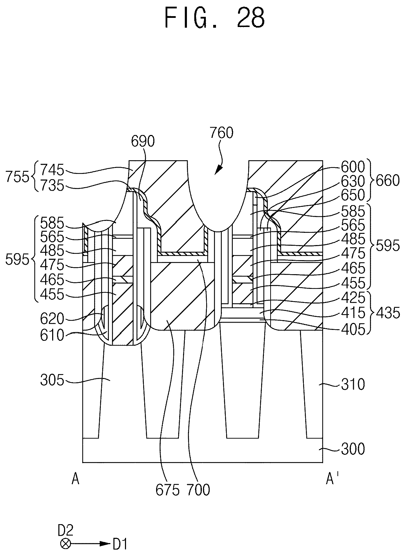

Referring to FIGS. 27 and 28, the second metal layer 740 and the second barrier layer 730 may be patterned to form an upper contact plug 755, and a ninth opening 760 may be formed between the upper contact plugs 755.

The ninth opening 760 may be formed by partially removing the first and second capping patterns 585 and 685, the preliminary spacer structure 660 and the fourth spacer 690 as well as the second metal layer 740 and the second barrier layer 730.

The upper contact plug 755 may include a second metal pattern 745 and a second barrier pattern 735 covering a lower surface of the second metal pattern 745. In some implementations, the upper contact plug 755 may have a shape of, e.g., a circle, an ellipse, a polygon, a polygon with rounded corners, etc., and may be arranged in a honeycomb pattern in the first and second directions D1 and D2.

The lower contact plug 675, the metal silicide pattern 700 and the upper contact plug 755 sequentially stacked may collectively form a contact plug structure.

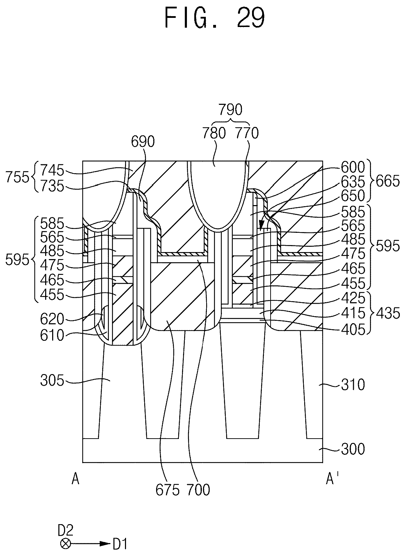

Referring to FIG. 29, the second spacer 630 included in the preliminary spacer structure 660 exposed by the ninth opening 760 may be removed to form an air gap, a sixth insulation pattern 770 may be formed on a bottom and a sidewall of the ninth opening 760, and a seventh insulation pattern 780 may be formed to fill a remaining portion of the ninth opening 760.

The sixth and seventh insulation patterns 770 and 780 may form a second insulation pattern structure 790.

A top of the air gap may be covered by the sixth insulation pattern 770, and thus an air spacer 635 may be formed. The first spacer 600, the air spacer 635 and the third spacer 650 may collectively form a spacer structure 665.

Referring to FIGS. 12 and 13 again, processes substantially the same as or similar to those illustrated with respect to FIGS. 3 to 9 may be performed to form the capacitor 110, the first etch stop layer 30, the support layer 50 and the upper plate electrode 120.

The lower electrode structure 70 of the capacitor 110 may contact an upper surface of the upper contact plug 775.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

The foregoing is illustrative of example implementations and is not to be construed as limiting thereof. Although a few example implementations have been described, those skilled in the art will readily appreciate that many modifications are possible in the example implementations without materially departing from the novel teachings and advantages of the present disclosure.

Embodiments are set out in the following clauses:
Clause 1. A capacitor structure comprising, a lower electrode structure including, a first lower electrode on a substrate; and a second lower electrode on a sidewall of the first lower electrode, the second lower electrode including an alloy of a first metal and a second metal; a dielectric pattern on a surface of the lower electrode structure; and an upper electrode on a surface of the dielectric pattern, wherein a thickness of the second lower electrode changes in a vertical direction, the vertical direction being perpendicular to an upper surface of the substrate, and wherein a weight ratio between the first metal and the second metal in the second lower electrode is uniform in the vertical direction.
Clause 2. The capacitor structure according to clause 1, wherein the first metal includes at least one of titanium, tantalum, tungsten, ruthenium, iridium, zirconium, hafnium, or niobium, and the second metal includes at least one of titanium, tantalum, tungsten, ruthenium, iridium, zirconium, hafnium, or niobium.
Clause 3. The capacitor structure according to clause 2, wherein the first metal includes titanium and the second metal includes niobium, and wherein the second lower electrode includes a nitride of an alloy of titanium and niobium.
Clause 4. The capacitor structure according to clause 1, 2 or 3, comprising a first support layer, a second support layer, and a third support layer sequentially stacked in the vertical direction on a sidewall of the lower electrode structure, wherein the dielectric pattern includes, a first portion beneath the first support layer; a second portion between the first support layer and the second support layer; and a third portion between the second support layer and the third support layer.
Clause 5. The capacitor structure according to clause 4, wherein the second lower electrode includes, a first portion overlapping the first support layer, the second support layer, and the third support layer in a horizontal direction, the horizontal direction being parallel to the upper surface of the substrate, a second portion overlapping the first portion of the dielectric pattern in the horizontal direction; a third portion overlapping the second portion of the dielectric pattern in the horizontal direction; and a fourth portion overlapping the third portion of the dielectric pattern in the horizontal direction, and wherein thicknesses of the first portion, the second portion, the third portion, and the fourth portion of the second lower electrode are different from each other.
Clause 6. The capacitor structure according to clause 5, wherein the thickness of the first portion of the second lower electrode is greater than the thickness of the second portion of the second lower electrode, the thickness of the second portion of the second lower electrode is greater than the thickness of the third portion of the second lower electrode, and the thickness of the third portion of the second lower electrode is greater than the thickness of the fourth portion of the second lower electrode.
Clause 7. The capacitor structure according to clause 5 or 6, comprising a first recess, a second recess, and a third recess, the first recess being defined by the first portion and the second portion of the second lower electrode and having a first depth, the second recess being defined by the first portion and the third portion of the second lower electrode and having a second depth greater than the first depth, and the third recess being defined by the first portion and the fourth portion of the second lower electrode and having a third depth greater than the second depth.
Clause 8. The capacitor structure according to any one previous clause, comprising support layers spaced apart from each other in the vertical direction on a sidewall of the lower electrode structure, wherein a thickness of a portion of the second lower electrode between the support layers in a horizontal direction gradually decreases from a bottom of the portion of the second lower electrode toward a top of the portion of the second lower electrode in the vertical direction, the horizontal direction being parallel to the upper surface of the substrate.
Clause 9. The capacitor structure according to any one previous clause, wherein the first lower electrode includes a conductive material having a stiffness greater than a stiffness of the alloy.
Clause 10. The capacitor structure according to any one previous clause, wherein the first lower electrode includes titanium silicon nitride.
Clause 11. The capacitor structure according to any one previous clause, comprising an upper plate electrode on an upper surface of the lower electrode structure, the upper plate electrode including doped silicon-germanium.
Clause 12. A capacitor structure comprising, a lower electrode structure including, a first lower electrode on a substrate, the first lower electrode extending in a vertical direction perpendicular to an upper surface of the substrate; and a second lower electrode on a sidewall of the first lower electrode, the second lower electrode including an alloy of niobium and titanium; a dielectric pattern on a sidewall of the lower electrode structure; and an upper electrode on a sidewall of the dielectric pattern, wherein a weight ratio between niobium and titanium in the second lower electrode is uniform in the vertical direction.
Clause 13. The capacitor structure according to clause 12, wherein a thickness of the second lower electrode changes in the vertical direction.
Clause 14. The capacitor structure according to clause 12 or 13, wherein a thickness of the first lower electrode is uniform in the vertical direction.
Clause 15. A semiconductor device comprising, an active pattern on a substrate; a gate structure in an upper portion of the active pattern, the gate structure extending in a first direction parallel to an upper surface of the substrate; a bit line structure extending in a second direction parallel to the upper surface of the substrate and crossing the first direction, the bit line structure being on a central portion of the active pattern; at least one contact plug structure on each of a first end portion and a second end portion of the active pattern, the first end portion being opposite to the second end portion; and a capacitor structure on the at least one contact plug structure, wherein the capacitor structure includes: at least one lower electrode structure, each lower electrode structure including: a first lower electrode extending in a vertical direction perpendicular to the upper surface of the substrate; and a second lower electrode on a sidewall of the first lower electrode, wherein a thickness of the second lower electrode changes in the vertical direction, and the second lower electrode includes an alloy of a first metal and a second metal; support layers spaced apart from each other in the vertical direction on a sidewall of the at least one lower electrode structure; a dielectric pattern on a sidewall of a portion of the at least one lower electrode structure between the support layers; and an upper electrode on a surface of the dielectric pattern, wherein a weight ratio between the first metal and the second metal in the second lower electrode is uniform in the vertical direction.
Clause 16. The semiconductor device according to clause 15, wherein the first metal includes titanium and the second metal includes niobium.
Clause 17. The semiconductor device according to clause 15 or 16, wherein the support layers include a first support layer, a second support layer, and a third support layer sequentially stacked in the vertical direction, and wherein the dielectric pattern includes: a first portion beneath the first support layer; a second portion between the first support layer and the second support layer; and a third portion between the second support layer and the third support layer.
Clause 18. The semiconductor device according to clause 17, wherein the second lower electrode includes: a first portion overlapping the first support layer, the second support layer, and the third support layer in a horizontal direction parallel to the upper surface of the substrate, a second portion overlapping the first portion of the dielectric pattern in the horizontal direction; a third portion overlapping the second portion of the dielectric pattern in the horizontal direction; and a fourth portion overlapping the third portion of the dielectric pattern in the horizontal direction, and wherein a thickness of the first portion of the second lower electrode is greater than a thickness of the second portion of the second lower electrode, the thickness of the second portion of the second lower electrode is greater than a thickness of the third portion of the second lower electrode, and a thickness of the third portion of the second lower electrode is greater than the thickness of the fourth portion of the second lower electrode.
Clause 19. The semiconductor device according to any one of clauses 15 to 18, wherein a thickness of a portion of the second lower electrode between the support layers in a horizontal direction gradually decreases from a bottom of the portion of the second lower electrode toward a top of the portion of the second lower electrode in the vertical direction, the horizontal direction being parallel to the upper surface of the substrate.
Clause 20. The semiconductor device according to any one of clauses 15 to 19, wherein the at least one contact plug structure is a plurality of contact plug structures spaced apart from each other in a horizontal direction parallel to the upper surface of the substrate, and the at least one lower electrode structure is a plurality of lower electrode structures spaced apart from each other in the horizontal direction, wherein each of the support layers extends in the horizontal direction between the plurality of lower electrode structures, and wherein the dielectric pattern contacts an upper surface or a lower surface of each of the support layers.
Clause 21. A method of forming a capacitor structure, the method comprising: alternately and repeatedly stacking mold layers and support layers on a substrate in a vertical direction perpendicular to an upper surface of the substrate; forming a lower electrode structure extending through the mold layers and the support layers, the lower electrode structure including a first lower electrode and a second lower electrode on a sidewall of the first lower electrode, and the second lower electrode having a single-layered structure and including an alloy of a first metal and a second metal; removing the mold layers by an etching process to form a first opening exposing a portion of the second lower electrode; and sequentially forming a dielectric pattern and an upper electrode in the first opening, wherein the portion of the second lower electrode exposed by the first opening is removed by the etching process so that the second lower electrode has a thickness varying in the vertical direction.
Clause 22. The method according to clause 21, wherein the etching process includes a wet etching process.
Clause 23. The method according to clause 21 or 22, wherein the etching process includes: performing a dry etching process to partially remove the mold layers and the support layers to form a second opening; and performing a wet etching process to remove the mold layers exposed by the second opening to form the first opening.
Clause 24. The method according to clause 23, wherein the support layers include first, second and third support layers sequentially disposed in the vertical direction, and wherein, during the etching process, a first recess having a first depth in a horizontal direction parallel to the upper surface of the substrate is formed at a portion of the second lower electrode between the substrate and the first support layer, and a second recess having a second depth in the horizontal direction greater than the first depth is formed at a portion of the second lower electrode between the second support layer and the third support layer.
Clause 25. The method according to clause 23 or 24, wherein the support layers include first, second and third support layers sequentially disposed in the vertical direction, and wherein a thickness in a horizontal direction parallel to the upper surface of the substrate of a portion of the second lower electrode between the substrate and the first support layer is greater than a thickness in the horizontal direction of a portion of the second lower electrode between the second support layer and the third support layer.
Clause 26. The method according to any one of clauses 21 to 25, wherein the support layers include first, second and third support layers sequentially disposed in the vertical direction, and the mold layers include first, second and third mold layers sequentially disposed in the vertical direction, and wherein the method further comprises: partially removing the third support layer by a first dry etching process to partially expose the third mold layer on the second support layer; removing the third mold layer by a first wet etching process; partially removing the second support layer by a second dry etching process to partially expose the second mold layer on the first support layer; removing the second mold layer by a second wet etching process; partially removing the first support layer by a third dry etching process to partially expose the first mold layer on the substrate; and removing the first mold layer by a third wet etching process.
Clause 27. The method according to clause 26, wherein performing each of the first to third wet etching processes includes removing a lateral portion of the second lower electrode, and wherein a thickness in a horizontal direction parallel to the upper surface of the substrate of a portion of the second lower electrode between neighboring ones of the first to third support layers gradually decreases from a bottom toward a top thereof in the vertical direction.
Clause 28. The method according to any one of clauses 21 to 27, wherein each of the first and second metals includes at least one of titanium, tantalum, tungsten, ruthenium, iridium, zirconium, hafnium and niobium.
Clause 29. The method according to any one of clauses 21 to 28, wherein the first metal includes titanium and the second metal includes niobium, and
   wherein the second electrode includes a nitride of an alloy of titanium and niobium.
Clause 30. The method according to any one of clauses 21 to 29, wherein the second lower electrode includes titanium silicon nitride.

## Claims

1. A capacitor structure comprising:
a lower electrode structure (70) including:
a first lower electrode (65) on a substrate (10); and
a second lower electrode (62) on a sidewall of the first lower electrode (65), the second lower electrode (62) including an alloy of a first metal and a second metal or a nitride of the alloy;
a dielectric pattern (95) on a surface of the lower electrode structure (70); and
an upper electrode (105) on a surface of the dielectric pattern (95), and
wherein a weight ratio between the first metal and the second metal in the second lower electrode (62) is uniform in the vertical direction.

2. The capacitor structure according to claim 1, wherein the first metal includes at least one of titanium, tantalum, tungsten, ruthenium, iridium, zirconium, hafnium, or niobium, and optionally the second metal includes at least one of titanium, tantalum, tungsten, ruthenium, iridium, zirconium, hafnium, or niobium.

3. The capacitor structure according to claim 2, wherein the first metal includes titanium and the second metal includes niobium, and wherein the second lower electrode (62) includes a nitride of an alloy of titanium and niobium.

4. The capacitor structure according to claim 1, 2 or 3, further comprising a first support layer (50), a second support layer (50), and a third support layer (50) sequentially stacked in the vertical direction on a sidewall of the lower electrode structure (70), wherein the dielectric pattern (95) includes:
a first portion beneath the first support layer (50);
a second portion between the first support layer (50) and the second support layer (50); and
a third portion between the second support layer (50) and the third support layer (50).

5. The capacitor structure according to claim 4, wherein the second lower electrode (62) includes:
a first portion overlapping the first support layer (50), the second support layer (50), and the third support layer (50) in a horizontal direction, the horizontal direction being parallel to the upper surface of the substrate (10),
a second portion overlapping the first portion of the dielectric pattern (95) in the horizontal direction;
a third portion overlapping the second portion of the dielectric pattern (95) in the horizontal direction; and
a fourth portion overlapping the third portion of the dielectric pattern (95) in the horizontal direction, and
wherein thicknesses of the first portion, the second portion, the third portion, and the fourth portion of the second lower electrode (62) are different from each other.

6. The capacitor structure according to claim 5, wherein the thickness of the first portion of the second lower electrode (62) is greater than the thickness of the second portion of the second lower electrode (62), the thickness of the second portion of the second lower electrode (62) is greater than the thickness of the third portion of the second lower electrode (62), and the thickness of the third portion of the second lower electrode (62) is greater than the thickness of the fourth portion of the second lower electrode (62).

7. The capacitor structure according to claim 5 or 6, further comprising a first recess, a second recess, and a third recess, the first recess being defined by the first portion and the second portion of the second lower electrode (62) and having a first depth, the second recess being defined by the first portion and the third portion of the second lower electrode (62) and having a second depth greater than the first depth, and the third recess being defined by the first portion and the fourth portion of the second lower electrode (62) and having a third depth greater than the second depth.

8. The capacitor structure according to any one of claims 1 to 7, further comprising support layers (50) spaced apart from each other in the vertical direction on a sidewall of the lower electrode structure (70), wherein a thickness of a portion of the second lower electrode (62) between the support layers (50) in a horizontal direction gradually decreases from a bottom of the portion of the second lower electrode (62) toward a top of the portion of the second lower electrode (62) in the vertical direction, the horizontal direction being parallel to the upper surface of the substrate (10).

9. The capacitor structure according to any one of claims 1 to 8, wherein the first lower electrode (65) includes a conductive material having a stiffness greater than a stiffness of the alloy.

10. The capacitor structure according to any one of claims 1 to 9, wherein the first lower electrode (65) includes titanium silicon nitride.

11. The capacitor structure according to any one of claims 1 to 10, further comprising an upper plate electrode (120) on an upper surface of the lower electrode structure (70), the upper plate electrode (120) including doped silicon-germanium.

12. The capacitor structure according to any one of claims 1 to 11, wherein the first lower electrode (65) extends in a vertical direction perpendicular to an upper surface of the substrate (10);
the second lower electrode (62) includes an alloy of niobium and titanium;
the dielectric pattern (95) is on a sidewall of the lower electrode structure (70); and
the upper electrode (105) is on a sidewall of the dielectric pattern (95), wherein a weight ratio between niobium and titanium in the second lower electrode (62) is uniform in the vertical direction.

13. The capacitor structure according to claim 12, wherein a thickness of the second lower electrode (62) changes in the vertical direction.

14. The capacitor structure according to claim 12 or 13, wherein a thickness of the first lower electrode (65) is uniform in the vertical direction.

15. A semiconductor device comprising:
an active pattern on a substrate (10);
a gate structure in an upper portion of the active pattern, the gate structure extending in a first direction parallel to an upper surface of the substrate (10);
a bit line structure extending in a second direction parallel to the upper surface of the substrate (10) and crossing the first direction, the bit line structure being on a central portion of the active pattern;
at least one contact plug structure on each of a first end portion and a second end portion of the active pattern, the first end portion being opposite to the second end portion; and
a capacitor structure according to any one of claims 1 to 14.
